Europäisches Patentamt

European Patent Office

Office européen des brevets

(11) Numéro de publication: **0 394 082**
**A1**

## (12) DEMANDE DE BREVET EUROPEEN

(21) Numéro de dépôt: **90400856.2**

(22) Date de dépôt: **29.03.90**

(51) Int. Cl.5: **G11C 19/08**

(30) Priorité: **31.03.89 FR 8904275**

(43) Date de publication de la demande:
**24.10.90 Bulletin 90/43**

(84) Etats contractants désignés:
**DE GB NL**

(71) Demandeur: **COMMISSARIAT A L'ENERGIE ATOMIQUE**
**31/33, rue de la Fédération**
**F-75015 Paris(FR)**

(72) Inventeur: **Fedeli, Marc**
**Le Mollard**
**F-38140 Beaucroissant(FR)**
Inventeur: **Magnin, Joel**
**3 rue Doyen Gosse**
**38400 Saint Martin d'Heres(FR)**

(74) Mandataire: **Mongrédien, André et al**
**c/o BREVATOME 25, rue de Ponthieu**
**F-75008 Paris(FR)**

(54) Dispositif de détection pour mémoire à bulles magnétiques.

(57) Dispositif de détection pour mémoire à bulles magnétiques comprenant une zone de détection (6) constituée de rangées (7) de motifs (8) aptes à la propagation des bulles sous forme de bande, et une zone de transition (10) permettant d'étirer les bulles sous forme de bande. Cette zone de transition (10) comporte au moins une rangée (18) de motifs en matériau magnétique doux ; cette rangée (18) comporte au moins un motif central (22) et un second motif (24) adjacent au motif central (22). Le motif central (22) possède une première partie (22a) apte à guider une bulle magnétique et une seconde partie (22b) apte à favoriser la propagation d'une bulle sous forme de bande. Le second motif (24) est apte à favoriser la propagation d'une bulle sous forme de bande tout en ne perturbant pas la propagation d'une bulle le long de la première partie (22a) du motif central (22).

FIG. 6

**DISPOSITIF DE DETECTION POUR MEMOIRE A BULLES MAGNETIQUES.**

La présente invention concerne, dans le domaine des mémoires à bulles magnétiques, la détection des bulles magnétiques et notamment l'étirement des bulles sous forme de bande au sortir d'un chemin de propagation et à l'entrée du dispositif de détection.

Dans une mémoire à bulles magnétiques, les bulles magnétiques sont contenues dans une couche magnétique monocristalline, telle qu'un film de grenat magnétique, supportée par un grenat monocristallin amagnétique. Ces bulles se présentent sous la forme de domaines magnétiques isolés, généralement cylindriques, présentant une aimantation inverse de celle du reste de la couche magnétique monocristalline. Ces bulles magnétiques sont stables par application d'un champ magnétique continu $H_{pol}$ perpendiculaire au plan de la couche magnétique. Dans la pratique, ce champ magnétique est créé par un aimant permanent assurant ainsi la non volatilité des informations contenues dans la mémoire à bulles.

Le déplacement des bulles est réalisé en appliquant un champ continu tournant $H_T$ suivant une direction parallèle à la surface de la couche magnétique. Le déplacement des bulles se fait autour de motifs dits de propagation.

Ces motifs présentant la forme de disques, de losanges, de triangles, de T, de chevrons, etc... peuvent être réalisés en un matériau magnétique doux, par exemple à base de fer et de nickel, appelé Permalloy, déposé sur une couche isolante recouvrant la couche magnétique, ou bien obtenues en implantant des ions dans la partie supérieure de la couche magnétique, à travers un masque permettant de définir la forme de ces motifs.

Le déplacement des bulles, le long des motifs de propagation s'effectue pendant environ une demi-période de rotation du champ magnétique tournant $H_T$. Pendant l'autre demi-période, les bulles transitent d'un motif au motif voisin. On réalise ainsi des registres à décalage dans lesquels l'information binaire "1" est représentée par la présence d'une bulle et l'information binaire "0" par l'absence d'une bulle.

La sortie d'une mémoire à bulles est constituée d'un chemin de propagation aboutissant à un ensemble de détection, qui constitue un moyen de lecture de la mémoire.

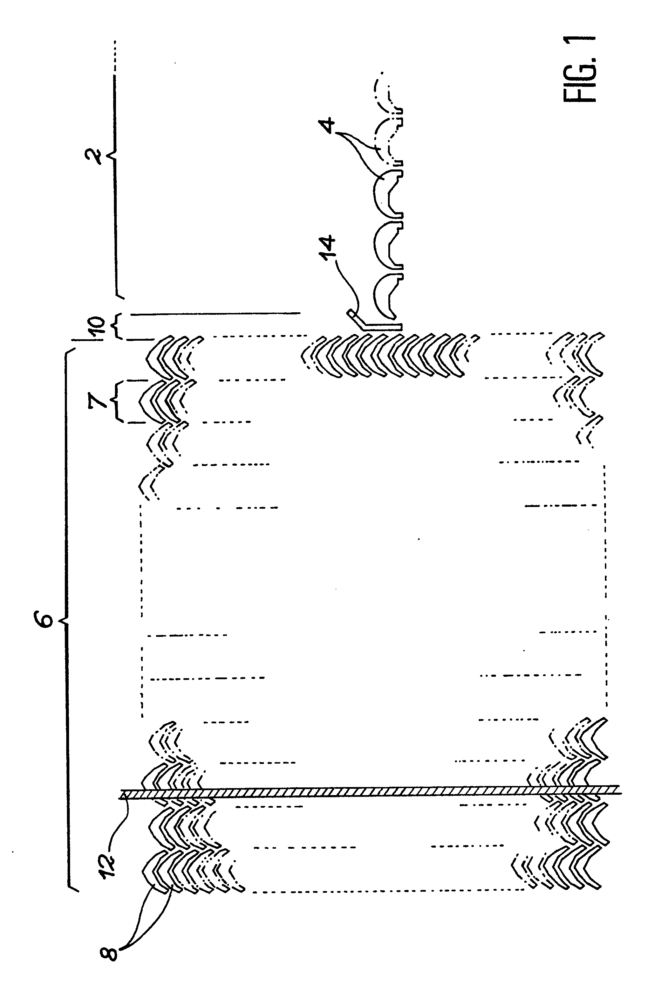

La figure 1 représente schématiquement une partie d'un ensemble de détection connu. Le chemin de propagation 2, constitué d'une succession de motifs de propagation 4 s'apparentant à des demi-lunes asymétriques, conduit les bulles représentant l'information à lire vers la zone de détection 6.

Cette zone 6 est composée de rangées 7 de motifs 8 s'apparentant à des chevrons pouvant éventuellement contenir successivement un nombre croissant de motifs 8.

Chaque bulle magnétique, avant d'arriver dans la zone de détection 6, traverse une zone de transition 10 qui favorise l'étirement de la bulle sous forme de bande. En effet, c'est sous la forme de bande que les bulles se propagent de rangée 7 en rangée 7 dans la zone de détection 6. Leur passage sous un élément magnétorésistif 12 permet leur détection. Les bulles sont ensuite évacuées.

Sur la figure 1, la zone de transition 10 est constituée par un motif 14 en forme de barre brisée sensiblement parallèle aux rangées 7 de la zone de détection 6.

La figure 2 représente schématiquement une vue partielle d'un ensemble de détection connu. On voit particulièrement la zone de transition 10 favorisant l'étirement des bulles provenant du chemin de propagation 2 et se propageant vers la zone de détection 6.

La zone de transition 10 est constituée d'une rangée de motifs 8 identique aux rangées 7 de la zone de détection 6. Mais deux motifs manquent à cette rangée supplémentaire de manière à isoler un groupe de trois motifs 8. Ces trois motifs sont dans le prolongement du chemin de propagation 2 ; ils sont aptes à la propagation des bulles sous forme de bande.

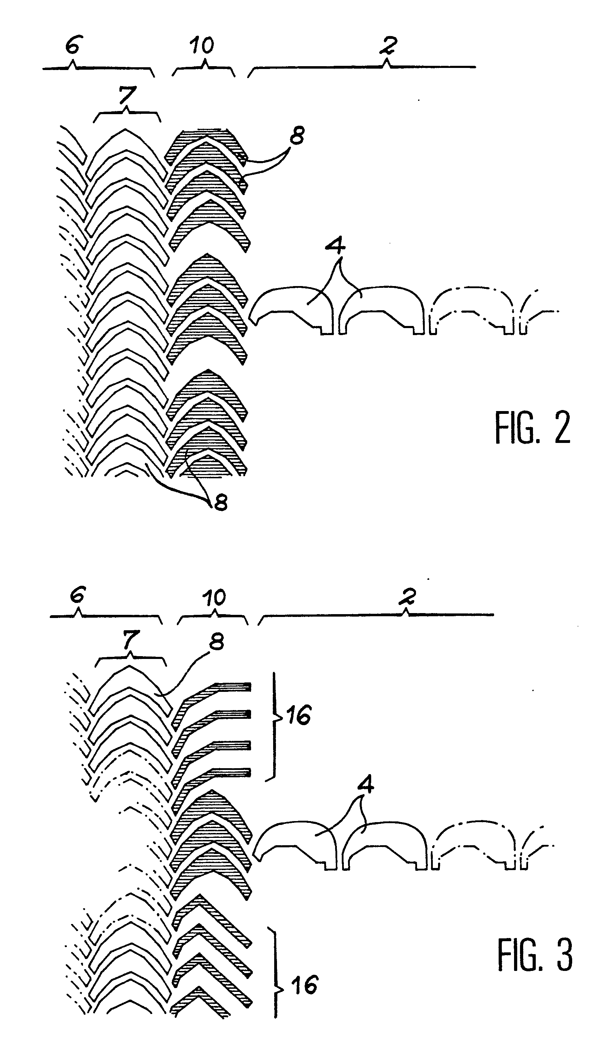

La figure 3 représente schématiquement un agrandissement partiel d'un autre ensemble de détection connu. Sur cette figure, la zone de transition 10 consiste en une rangée de motifs. Trois de ces motifs, situés dans le prolongement du chemin de propagation 2 sont identiques aux motifs 8 des rangées 7 de la zone de détection 6. Les autres motifs 16 de la rangée constituant la zone de transition 10 présentent une première partie telle qu'elle n'influe pas sur la propagation des bulles et une seconde partie favorisant la propagation sous forme de bande. Dans cette réalisation aussi, le groupe des trois motifs permet une propagation des bulles sous forme de bande.

De telles mémoires à bulles magnétiques fonctionnent correctement pour une valeur de champ magnétique de polarisation $H_{pol}$ comprise dans un intervalle communément appelé marge. Cette marge possède une valeur inférieure communément appelée bas de marge ou bas champ et une valeur supérieure communément appelée haut de marge ou haut champ. Plus la marge est importante et plus la mémoire à bulles accepte des écarts par rapport aux valeurs nominales de fonctionnement. Par exemple, en augmentant la marge, les tolérances sur la précision de la géométrie des motifs ou sur les conditions de température de fonctionnement sont améliorées.

De manière usuelle, pour une bulle magnétique d'un diamètre de 1 micron, on obtient un bas de marge de 400 oe et un haut de marge de 430 oe. (1 oe égale $1/4\pi10^{-3}$A/m).

La zone de transition des ensembles de détection connus constitue une limitation importante de la marge ; en effet, lorsque l'on fait fonctionner la mémoire à bulles magnétiques en haut de marge, le passage d'une bulle du dernier motif de propagation à la zone de transition s'effectue mal : la bulle a tendance à disparaître au lieu de s'étirer en bande.

Le but de la présente invention est d'augmenter la marge de manière à obtenir un plus grand domaine de fonctionnement des mémoires à bulles magnétiques. Pour cela l'invention préconise d'élever la valeur du haut de marge en modifiant la zone de transition de manière à ce que l'étirement ne s'effectue pas de manière brutale lors du passage d'un motif guidant une bulle à un motif favorisant une propagation sous forme de bande. Dans l'invention, l'étirement s'effectue progressivement lors de la propagation à l'intérieur de la zone de transition, grâce à une géométrie particulière des motifs de cette zone.

De façon plus précise, l'invention concerne un dispositif de détection pour mémoires à bulles magnétiques comprenant :
- une zone de détection constituée de rangées de motifs en matériau magnétique doux, les bulles issues d'un chemin de propagation composé de motifs de propagation en matériau magnétique doux se propageant sous forme de bande dans cette zone de détection,
- une zone de transition entre la zone de détection et le chemin de propagation permettant d'étirer sous forme de bande les bulles issues du chemin de propagation.

La zone de transition comporte au moins une rangée de motifs en matériau magnétique doux, cette rangée comportant au moins un motif central dans le prolongement du chemin de propagation et un second motif adjacent au motif central. Ledit motif central possède une première partie apte à guider une bulle magnétique et une seconde partie apte à favoriser la propagation d'une bulle sous forme de bande. Ledit second motif est apte à favoriser la propagation d'une bulle sous forme de bande tout en ne perturbant pas la propagation de cette bulle le long de la première partie du motif central.

L'étirement de la bulle s'effectue donc lors de la propagation le long du motif central et non lors d'un saut entre deux types de motifs différents.

Les bulles lors de leur propagation sous forme de bande sont allongées perpendiculairement à la direction de propagation des bulles le long du chemin de propagation.

Selon une variante de réalisation du dispositif, ladite rangée de la zone de transition comporte un troisième motif adjacent au motif central et étant apte à favoriser la propagation d'une bulle sous forme de bande tout en ne perturbant pas la propagation d'une bulle le long de la première partie du motif central.

Selon une autre variante de réalisation, ladite rangée de la zone de transition comporte des motifs supplémentaires de part et d'autre du groupe constitué par le motif central et les second et éventuellement troisième motifs. Ces motifs supplémentaires sont aptes à favoriser la propagation d'une bulle sous forme de bande tout en ne perturbant pas la propagation d'une bulle le long de la première partie du motif central.

Ainsi, au sortir de la zone de transition, une bulle est étirée sous forme de bande sans passage brutal entre des motifs guidant les bulles et des motifs les propageant sous forme de bande.

Selon un autre mode de réalisation, les motifs supplémentaires sont séparés dudit groupe par un espace correspondant à une absence d'au moins un des motifs supplémentaires de part et d'autre dudit groupe.

Dans ce cas, les motifs supplémentaires permettent de réduire l'importance des pôles des motifs de la rangée suivante, pour un bas champ.

Les caractéristiques et avantages de l'invention apparaîtront mieux après la description qui suit donnée à titre explicatif et nullement limitatif. Cette description se réfère à des dessins sur lesquels :
- la figure 1, déjà décrite, représente schématiquement une partie d'un ensemble de détection d'une mémoire à bulles magnétiques selon l'art antérieur,
- la figure 2, déjà décrite, représente schématiquement une vue partielle d'un autre ensemble de detection selon l'art antérieur,
- la figure 3, déjà décrite, représente schématiquement une vue partielle d'un autre ensemble de détection selon l'art antérieur,

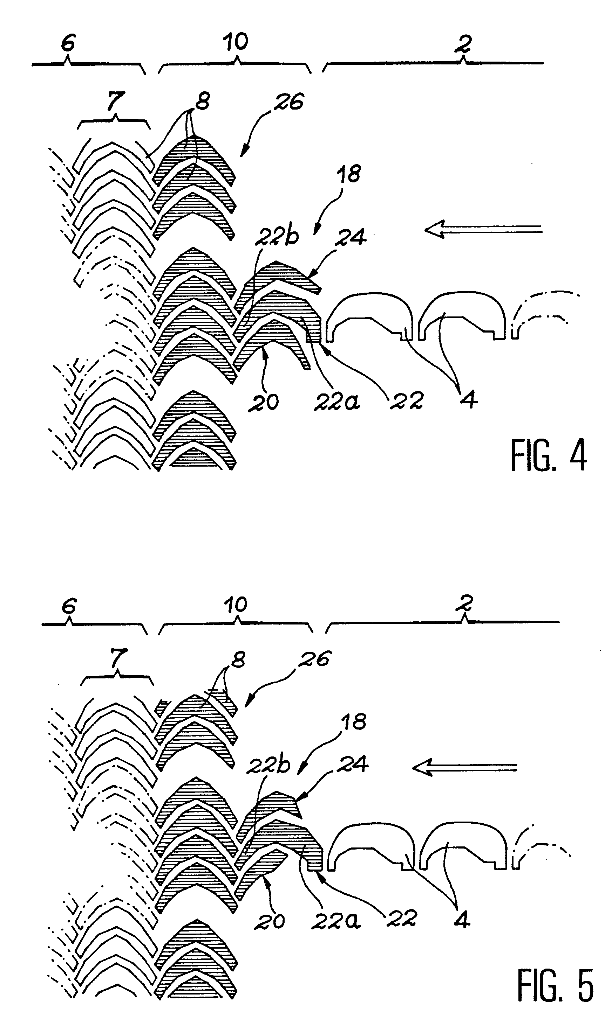

- la figure 4 représente schématiquement une vue partielle d'un dispositif de détection selon l'invention,
- la figure 5 représente schématiquement un agrandissement d'une zone de transition d'un dispositif de détection selon l'invention,

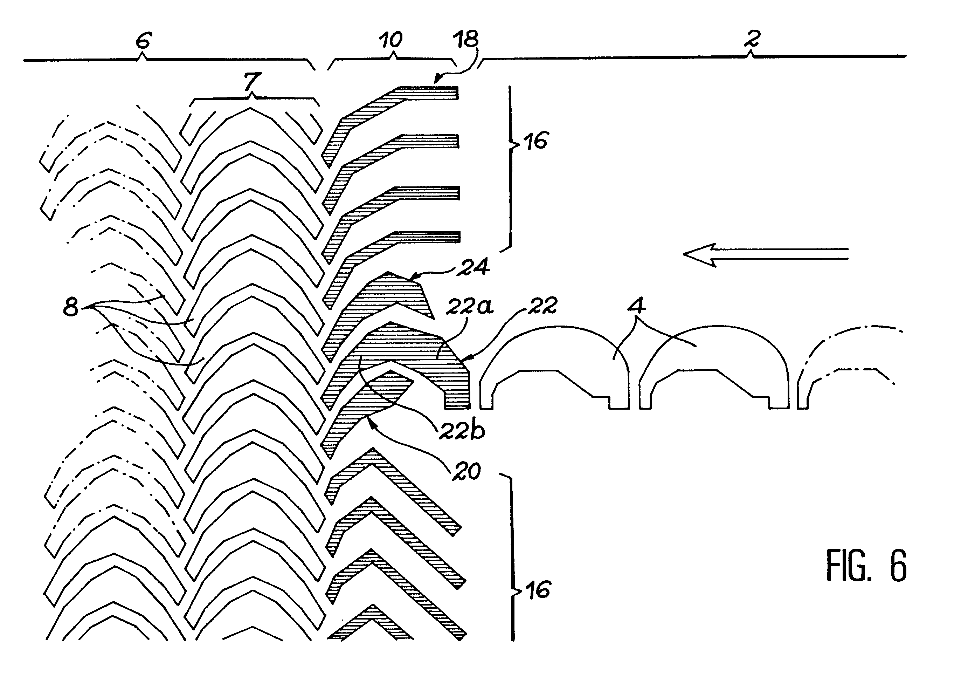

- la figure 6 représente schématiquement une vue partielle d'une variante de réalisation d'un dispositif de détection selon l'invention,

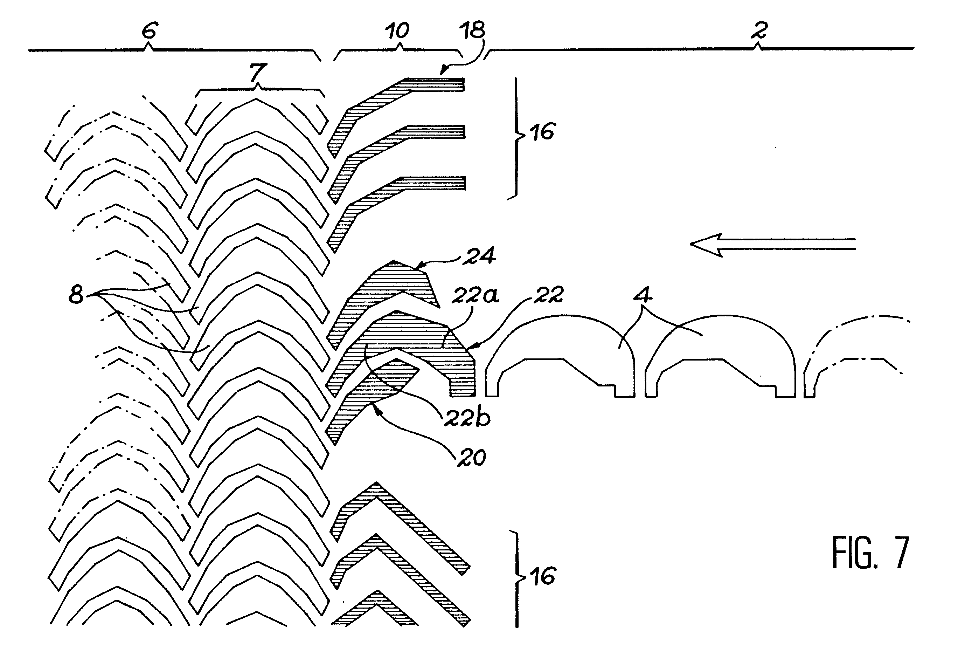

- la figure 7 représente schématiquement une vue partielle d'un autre mode de réalisation d'un dispositif de détection selon l'invention.

La figure 4 représente schématiquement une vue partielle d'un dispositif de détection selon l'invention. Sur cette figure, on voit que la zone de transition 10 est constituée de deux rangées de motifs en matériau magnétique doux, du permalloy par exemple.

Une première rangée 18 contiguë au chemin de propagation 2 ne contient que trois motifs 20, 22, 24. Le motif central 22 situé dans le prolongement du chemin de propagation 2 comporte une première partie 22a apte à guider une bulle magnétique et une seconde partie 22b apte à favoriser la propagation d'une bulle sous forme de bande.

Dans l'exemple de réalisation représenté, la géométrie de la première partie 22a du motif central 22 s'apparente à la géométrie de la première partie d'un motif de propagation 4. Par contre, la seconde partie 22b présente une géométrie proche de celle de la seconde partie d'un motif 8 appartenant à une rangée 7 de la zone de détection 6.

De ce fait, la section de la première partie du motif central est supérieure à la section de sa deuxième partie.

Par exemple, pour la propagation et l'étirement d'une bulle de 1 micron de diamètre, la première partie 22a du motif central peut présenter une section de l'ordre de 5 microns et sa deuxième partie, une section de l'ordre de 1,5 micron.

Grâce notamment à ce motif 22, la bulle s'étire progressivement sous forme de bande et non de manière brutale lors d'un saut entre deux motifs.

Au moins un second motif apte à favoriser la propagation d'une bulle sous forme de bande, adjacent au motif central 22 permet à l'étirement de la bulle de s'effectuer.

Dans le cas où seul un second motif est présent, ce dernier est positionné au-dessus du motif principal 22 ; c'est-à-dire que, si, comme représenté sur la figure 4, le motif central 22 a une forme s'apparentant à un croissant, le second motif est positionné au-dessus de la convexité du motif central 22.

Dans la réalisation représentée sur la figure 4, la rangée 18 comporte deux motifs 20, 24 de part et d'autre du motif central 22.

Ces deux motifs 20, 24 sont tels qu'ils favorisent la propagation d'une bulle sous forme de bande tout en ne perturbant pas la propagation de la bulle sur la première partie 22a du motif central 22. On voit que les extrémités des motifs 20, 24 adjacents au motif central 22 sont écartées de la partie 22a pour s'en rapprocher progressivement. D'autre part, pour ne pas perturber la propagation des bulles sur les motifs de propagation 4 et leur saut sur le motif central 22, les extrémités des motifs 20 et 24 sont éloignées du dernier motif de propagation 4 d'une distance égale au moins à trois fois le diamètre d'une bulle.

Cette première rangée 18 peut être suivie (selon le sens de propagation symbolisé par une flèche sur la figure 4) par une seconde rangée 26. Les motifs 8 de cette dernière sont identiques à ceux d'une rangée 7 de la zone de détection 6. Deux motifs sont manquants, isolant ainsi un groupe de quatre motifs situés dans le prolongement des motifs 20, 22, 24 de la première rangée 18.

Une bulle s'étire sous forme de bande au passage par la première rangée 18 et s'allonge encore au passage par la seconde rangée 26 sur ces quatre motifs.

Une bulle sous forme de bande est allongée perpendiculairement à la direction de propagation des bulles le long du chemin de propagation. En d'autres termes, l'orientation des motifs 4 du chemin de propagation est identique à celle des chevrons des zones 10, 6 de transition et de détection.

La bulle sous forme de bande se propage ensuite dans la zone de détection 6 pour être lue.

La figure 5 représente schématiquement un agrandissement d'une zone de transition 10 d'un dispositif de détection selon l'invention. Dans cet exemple de réalisation, la zone de transition 10 comporte deux rangées 18 et 26 de motifs. La première rangée 18 est constituée de trois motifs 20, 22, 24. Les motifs 20, 24 adjacents au motif central 22 n'occupent pas toute la largeur de la rangée 18. Seules sont présentes les parties de ces motifs 20, 24 adjacentes à la seconde partie 22b du motif central 22. De ce fait, la propagation d'une bulle n'est pas perturbée lors du cheminement le long de la première partie 22a du motif central 22. Par contre, lors du cheminement le long de la seconde partie 22b, la bulle subit l'influence des pôles magnétiques constitués par les motifs 20 et 24, ce qui favorise son étirement progressif.

La seconde rangée 26 est identique à celle représentée sur la figure 4.

La figure 6 représente schématiquement une vue partielle d'une variante de réalisation d'un dispositif de détection selon l'invention. La zone de transition 10 n'est constituée que d'une rangée 18. Le motif central 22 et les motifs 20, 24 adjacents sont identiques à ceux représentés sur la figure 5.

La rangée 18 comporte des motifs supplémentaires 16 situés de part et d'autre du groupe constitué par le motif central 22 et les motifs adjacents 20, 24. Ces motifs supplémentaires 16 sont aptes à favoriser la propagation d'une bulle sous forme de bande tout en ne perturbant pas la propagation d'une bulle le long de la première partie 22a du motif central 22.

La figure 7 représente un autre mode de réalisation de la variante représentée sur la figure 6. On voit que les motifs supplémentaires 16 sont séparés du groupe constitué par le motif central 22 et les motifs adjacents 20, 24 par un espace. Cet espace correspond à l'absence d'un motif supplémentaire de part et d'autre du groupe central.

En bas champ, ces motifs supplémentaires permettent de réduire l'importance des pôles des motifs de la rangée suivante.

La zone de transition d'un dispositif de détection selon l'invention permet donc un étirement progressif d'une bulle sous forme de bande. Les performances d'une mémoire à bulles magnétiques utilisant un tel dispositif sont améliorées : la marge est augmentée. On obtient par exemple une marge de 40 oe pour un bas champ, de 400 oe (pour un diamètre de bulle égal à 1 micron), ce qui constitue une amélioration d'environ 10 oe par rapport aux performances des dispositifs connus.

**Revendications**

1. Dispositif de détection pour mémoire à bulles magnétiques comprenant :
- une zone de détection (6) constituée de rangées (7) de motifs (8) en matériau magnétique doux, les bulles magnétiques se propageant sous forme de bande dans cette zone (6),
- une zone de transition (10) permettant d'étirer sous forme de bande les bulles issues d'un chemin de propagation (2) composé de motifs de propagation (4) en matériau magnétique doux,
caractérisé en ce que la zone de transition (10) comporte au moins une rangée (18) de motifs en matériau magnétique doux, cette rangée (18) comportant au moins un motif central asymétrique (22) dans le prolongement du chemin de propagation et un second motif asymétrique (24) adjacent au motif central (22), ledit motif central (22) possédant une première partie (22a) apte à guider une bulle magnétique et une seconde partie (22b) apte à favoriser la propagation d'une bulle sous forme de bande, ledit second motif (24) étant apte à favoriser la propagation d'une bulle sous forme de bande tout en ne perturbant pas la propagation d'une bulle le long de la première partie (22a) du motif central (22), les bulles se propageant sous forme de bande étant allongées perpendiculairement à la direction de propagation des bulles le long du chemin de propagation.

2. Dispositif selon la revendication 1, caractérisé en ce que ladite rangée (18) de la zone de transition (10) comporte un troisième motif asymétrique (20) adjacent au motif central (22) et apte à favoriser la propagation d'une bulle sous forme de bande tout en ne perturbant pas la propagation d'une bulle le long de la première partie (22a) du motif central (22).

3. Dispositif selon la revendication 2, caractérisé en ce que ladite rangée (18) de la zone de transition (10) comporte des motifs supplémentaires (16) de part et d'autre du groupe constitué par le motif central (22) et les second et troisième motifs (24, 20), ces motifs supplémentaires (16) étant aptes à favoriser la propagation d'une bulle sous forme de bande tout en ne perturbant pas la propagation d'une bulle le long de la première partie (22a) du motif central (22).

4. Dispositif selon la revendication 2, caractérisé en ce que ladite rangée (18) de la zone de transition (10) comporte des motifs supplémentaires (16) de part et d'autre du groupe constitué par le motif central (22) et les second et troisième motifs (24, 20), ces motifs supplémentaires (16) étant séparés dudit groupe par un espace correspondant à une absence d'au moins un de ces motifs (16) de part et d'autre dudit groupe.

5. Dispositif selon la revendication 1, caractérisé en ce que la première partie (22a) du motif central (22) présente une section supérieure à la section de la deuxième partie (22b) du motif central (22).

6. Dispositif selon la revendication 1, caractérisé en ce que le second motif (24) présente une extrémité éloignée du dernier motif de propagation (4) d'une distance égale au moins à trois fois le diamètre d'une bulle.

7. Dispositif selon la revendication 2, caractérisé en ce que le troisième motif (20) présente une extrémité éloignée du dernier motif de propagation (4) d'une distance égale au moins à trois fois le diamètre d'une bulle.

FIG. 1

EP 0 394 082 A1

FIG. 2

FIG. 3

FIG. 4

FIG. 5

FIG. 6

FIG. 7

EP 0 394 082 A1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | WO-A-8 103 237 (ROCKWELL INTERNATIONAL) * Page 5, ligne 18 - page 6, ligne 13; figures 3,4 * | 1,2 | G 11 C  19/08 |
| A | US-A-4 460 976 (AT & T BELL LABORATORIES) * Colonne 2, ligne 29 - colonne 4, ligne 11; figures 1,2 * | 1,2,4 | |
| A | US-A-4 502 129 (HITACHI) * Colonne 5, ligne 1 - colonne 6, ligne 9; figures 5,6 * | 1 | |
| A | PATENT ABSTRACTS OF JAPAN, vol. 8, no. 68 (P-264)[1505], 30 mars 1984; & JP-A-58 215 782 (FUJITSU K.K.) 15-12-1983 | 3 | |
| A | PATENT ABSTRACTS OF JAPAN, vol. 7, no. 180 (P-215)[1325], 9 août 1983; & JP-A-58 83 378 (HITACHI SEISAKUSHO K.K.) 19-05-1983 | | DOMAINES TECHNIQUES RECHERCHES (Int. Cl.5) G 11 C  19/08 |
| A | EP-A-0 073 305 (IBM) * Page 4, lignes 13-19; figure 2 * | 1 | |
| A | PATENT ABSTRACTS OF JAPAN, vol. 5, no. 77 (P-062), 21 mai 1981; & JP-A-56 025 282 (OKI ELECTRIC IND. CO., LTD) 11-03-1981 | 1,2,4 | |

Le présent rapport a été établi pour toutes les revendications

| Lieu de la recherche | Date d'achèvement de la recherche | Examinateur |
|---|---|---|
| LA HAYE | 02-08-1990 | DEGRAEVE L.W.G. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)